(19) Europäisches Patentamt
European Patent Office
Office européen des brevets

(11) Veröffentlichungsnummer : **0 522 998 A2**

(12) # EUROPÄISCHE PATENTANMELDUNG

(21) Anmeldenummer : **92810345.6**

(51) Int. Cl.$^5$ : **H04L 27/22**

(22) Anmeldetag : **08.05.92**

(30) Priorität : **09.07.91 CH 2043/91**

(43) Veröffentlichungstag der Anmeldung : **13.01.93 Patentblatt 93/02**

(84) Benannte Vertragsstaaten : **AT CH DE FR GB LI SE**

(71) Anmelder : **ASCOM TECH AG
Freiburgstrasse 370
CH-3018 Bern 18 (CH)**

(72) Erfinder : **Fawer, Urs
Schulstrasse 9
CH-5415 Nussbaumen (CH)**

(74) Vertreter : **Roshardt, Werner Alfred et al
Dr. R. Keller + Partner Patentanwälte
Marktgasse 31 Postfach
CH-3000 Bern 7 (CH)**

(54) **Verfahren zum Schätzen des Frequenzversatzes in einemm Quadraturempfänger.**

(57) Ein Verfahren zum Schätzen des Frequenzversatzes eines Empfängeroszillators (1) gegenüber der Trägerfrequenz (f) eines Sendesignals (s(t)) wertet Entscheidungsvariable und Ausgangssignal ($\underline{Y}$[k] resp. $\underline{d}$[k]) eines Quadraturmodulationsempfängers gemäss folgender Beziehung aus :

$$\hat{\Delta}_f T = \frac{1}{2\pi c} \arg\left(\underline{Y}[k]\cdot(\underline{\hat{d}}[k])^*\right)$$

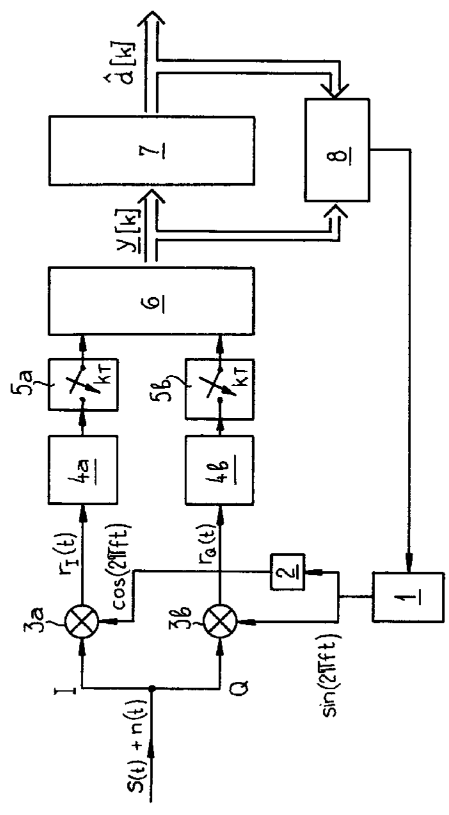


Fig.1

EP 0 522 998 A2

Jouve, 18, rue Saint-Denis, 75001 PARIS

## Technisches Gebiet

Die Erfindung betrifft ein Verfahren zum Schätzen des Frequenzversatzes eines Empfängeroszillators gegenüber der Trägerfrequenz eines Sendesignals, welches M-wertige digitale Daten, die in Form von Symbolen einer Trägerschwingung im Sinn eines Quadraturmodulationsverfahrens aufmoduliert sind, übermittelt, wobei im Empfänger

a) zuerst mit Hilfe des Empfängeroszillators das Empfangssignal zu einem Basisbandsignal heruntergemischt wird,

b) dann entweder - im Fall einer kohärenten Demodulation - eine Phasensynchronisation erfolgt, die ein phasenkorrigiertes Signal $\underline{Y}[k]$ von der Form

$$E[\underline{Y}[k]] = A_o e^{j2\pi c \Delta f t} \underline{d}[k] ,$$

wobei

E[.] = Erwartungswert
T = Symbolintervall
$\Delta f$ = Frequenzversatz
$\underline{d}[k]$ = Symbol

oder - im Fall einer nichtkohärenten Demodulation - eine Phasendifferenzdetektion zur Ermittlung der differentiellen Phase von der Form

$$\underline{Y}[k] = \underline{r}[k] \cdot (\underline{r}[k - l]) * ,$$

wobei

$\underline{r}[k]$ = Abtastwert des komplexwertigen Basisbandsignals,

liefert und

c) aus dem phasenkorrigierten Signal resp. der differentiellen Phase das entsprechende übermittelte Symbol geschätzt wird.

## Stand der Technik

In jedem reellen elektrischen Nachrichtenübertragungssystem ist, bedingt durch Fertigungstoleranzen und Nichtidealitäten, ein Frequenzversatz zwischen dem Empfangssignal und dem lokalen Trägerfrequenzoszillator anzutreffen, der unter Umständen die Zuverlässigkeit der Datenübertragung empfindlich beeinträchtigt. So treten beispielsweise bei Trägerfrequenzen im Bereich von 900 MHz bei den heute zur Verfügung stehenen Empfängern ein Frequenzfehler von mehreren kHz auf. Es sind Verfahren zur Korrektur dieses Frequenzfehlers bekannt, die allerdings entweder eine analoge Signalverarbeitung oder eine Abtastung mit einer höheren Rate als der Symbolrate (Quadrikorrelationsverfahren, schnelle Fouriertransformation) erfordern.

Bei der Anwendung eines kohärenten Quadraturmodulationsverfahrens muss im Empfänger die Phase korrigiert werden. Entsprechende Schätzalgorithmen sind in den verschiedensten Variationen bekannt. Als Beispiel sei die Trägerphasenschätzung angeführt, die im Artikel "Maximum Likelihood Carrier Phase Recovery for Linear Suppressed-Carrier Digital Data Modulations", Pooi Yuen Kam, IEEE Transactions on Communications, Vol. COM-34, No. 6, June 1986, beschrieben ist. Dabei wird eine ML-Schätzung (ML = Maximum Likelihood) aufgrund der letzten N-Symbole durchgeführt. Es findet somit eine Entscheidungsrückführung (Decision Feedback) statt. Prinzipiell wird vorausgesetzt, dass die Phasen über die letzten NT Symbole zeitinvariant ist. Für den Fall eines Frequenzversatzes ist diese Bedingung nicht erfüllt und demzufolge die Synchronisation nicht optimal.

Aus der Veröffentlichung "Coded 8-DPSK Modulation with Differentially Coherent Detection - an Efficient Modulation Scheme for Fading Channels", Franz Edbauer, GLOBECOM '87, S. 42.2.1 bis 42.2.4, ist ein Verfahren zur Kompensation des Frequenzversatzes bei einem nicht-kohärenten Quadraturmodulationsverfahren bekannt. Konkret geht es um ein trelliskodiertes, differentielles 8-PSK-Verfahren (PSK = Phase Shift Keying), das mit einem AFC-Regler (AFC = Automatic Frequency Control) ausgestattet ist. Der Input für den AFC-Regler ist ein Fehlersignal, das im wesentlichen die Korrektur vorzeichenmässig charakterisiert. Der Frequenzversatz wird also nicht quantitativ geschätzt, es werden nur Massnahmen getroffen, um ihn möglichst zu eliminieren. Auch diese Nachregelung des Frequenzversatzes ist somit in keiner Weise optimal.

## Darstellung der Erfindung

Aufgabe der Erfindung ist es, ein Verfahren zur Verbesserung der Empfängersynchronisation für Quadraturmodulationsverfahren der eingangs genannten Art anzugeben.

Gemäss der Erfindung besteht die Lösung darin, dass aus dem phasenkorrigierten Signal resp. der differentiellen Phase und dem entsprechenden geschätzten Symbol der Frequenzversatz zumindest näherungs-

weise gemäss der Beziehung

$$\hat{\Delta}_f T = \frac{1}{2\pi c} \arg\left(\underline{Y}[k] \cdot (\hat{\underline{d}}[k])^*\right)$$

ermittelt wird.

Mit diesem Verfahren kann der Phasenfehler verkleinert werden, ohne dass eine Erhöhung der Abtastrate nötig wäre. Es lässt sich auf digitaler Ebene und mit geringem Aufwand realisieren. Grundsätzlich können damit alle bekannten Quadraturmodulationsverfahren (nämlich QAM, MPSK, MDPSK u. dgl.) verbessert werden.

Vorzugsweise wird die erfindungsgemässe Formel exakt ausgewertet. In diesem Fall liegt ein erwartungstreuer Schätzwert, d. h. ein Wert, der genau dem effektiven Frequenzversatz entspricht, vor. In diesem Fall kann der geschätzte Frequenzversatz unmittelbar oder in gefilterter Form den Empfängeroszillator zur Kompensation des Frequenzversatzes zugeführt werden. Entsprechend kann eine schnelle und präzise Führung des lokalen Oszillators erreicht werden. Ebenso kann der Frequenzversatz mit einem Regelkreis kompensiert werden.

Bei kleinen Phasenfehlern kann der Rechenaufwand durch eine Linearisierung der erfindungsgemässen Formel beträchtlich erniedrigt werden. In diesem Fall empfiehlt es sich, einen kleinen Regelkreis zum Nachregeln des Oszillators aufzubauen. Das Resultat einer solchen Regelschlaufe ist aber nach wie vor beträchtlich besser als beim Stand der Technik, weil sich letzterer im wesentlichen nur auf eine vorzeichenmässige Kompensation abstützt.

Um die Fluktuationen des geschätzten Frequenzversatzes vom lokalen Oszillator fernzuhalten, empfiehlt es sich, über mehrere Symbolperioden, insbesondere 10-100 Symbolintervalle zu mitteln.

Aus der nachfolgenden Beschreibung und den Zeichnungen ergeben sich weitere vorteilhafte Ausführungsformen der Erfindung.

**Kurze Beschreibung der Zeichnungen**

Nachfolgend soll die Erfindung anhand von Ausführungsbeispielen und im Zusammenhang mit den Zeichnungen näher erläutert werden. Es zeigen:

Fig. 1 Ein Blockschaltbild eines Empfängers mit einer erfindungsgemässen Frequenzversatzschätzung;

Fig. 2 eine Darstellung des Prinzips der Erfindung;

Fig. 3 eine Darstellung der Wirkung der erfindungsgemässen Phasensynchronisation; und

Fig. 4 ein Blockschaltbild des Frequenzversatzschätzers.

Grundsätzlich sind in den Zeichnungen gleiche Teile mit gleichen Bezugszeichen versehen.

**Wege zur Ausführung der Erfindung**

Fig. 1 zeigt ein Blockschaltbild eines kohärent demodulierenden Empfängers. Am Eingang der Empfängerschaltung liegt ein Empfangssignal r(t) = s(t) + n(t) (n(t) = Rauschsignal), das in bekannter Weise zu einem Basisbandsignal $\underline{r}(t)$ heruntergemischt wird. D. h., das Empfangssignal s(t) + n(t) wird in einem ersten resp. zweiten Multiplizierer 3a, 3b mit cos($2\pi f t$) resp. sin($2\pi f t$) multipliziert. Die Trägerfrequenz f wird dabei von einem Empfängeroszillator 1 erzeugt. Mit einem Phasenschieber 2, der eine 90°-Drehung einführt, werden die benötigten, orthogonalen Signalkomponenten erzeugt. Das resultierende Basisbandsignal $\underline{r}(t)$ lässt sich mit Hilfe der Inphasen- und der Quadraturkomponente $r_I(t)$ resp. $r_Q(t)$ als komplexe Enveloppe im Basisband beschreiben.

Das Basisbandsignalband $\underline{r}(t)$ wird von einem Matched Filter 4a, 4b gefiltert, zu den Zeitpunkten kT mit Signalabtastern 5a, 5b abgetastet und einer Phasensynchronisationsschaltung 6 zugeführt. Die Uebertragungsfunktion des Matched Filters 4a resp. 4b ist an die Pulsform p(t) des quadraturmodulierten Sendesignals angepasst. Das Sendesignal ist gegeben durch

$$s(t) = \sqrt{2P}\ \mathrm{Re}\left\{ e^{j2\pi f_o t}\left( \sum_{k=-\infty}^{\infty} p(t-kT)\underline{d}[k] \right) \right\}.$$

T bezeichnet dabei die Symboldauer, fo die Trägerfrequenz des Sendesignals, P die Sendeleistung und

$\underline{d}[k]$ das Symbol zum Abtastzeitpunkt k. Die Werte, die das k-te Symbol annehmen kann, sind durch die Modulationsart vorgegeben und liegen in der komplexen Ebene.

Die Phasensynchronisationsschaltung 6 schätzt die Trägerphase des Empfangssignals und dreht entsprechend das abgetastete Basisbandsignal. Damit steht ein phasenkorrigiertes Signal $\underline{Y}[k]$ zur Verfügung, das in einem Symboldetektor 7 ausgewertet wird. Die Auswertung beruht z. B. auf dem Maximum-Likelihood- Prinzip und führt zu geschätzten Symbolen $\hat{\underline{d}}[k]$.

Der bis anhin beschriebene Teil des Empfängers geht nicht über das aus dem Stand der Technik Bekannte hinaus. Das eigentlich Neue der Erfindung stellt der Frequenzversatzschätzer 8 dar. Er soll im folgenden anhand seiner grundlegenden Funktionsweise und einiger Beispiele erläutert werden.

Bei einem kohärenten Quadraturmodulationsverfahren, wie beispielsweise dem MPSK-Verfahren führt die Phasensynchronisationsschaltung 6 eine auf den letzten N Abtastwerten des Basisbandsignals beruhende Korrektur durch. Unabhängig davon, wie diese Korrektur durchgeführt wird, führt sie zu einem Signal, dessen Erwartungswert mit folgender Formel allgemein darstellbar ist:

$$E[\underline{Y}[k]] = A_o e^{j2\pi c\Delta ft}\underline{d}[k]\,, \quad \text{(I)}$$

$A_o$ ist eine konstante Amplitude, $\Delta fT$ der zu schätzende relative Frequenzversatz und c eine positive Konstante, die von der gewählten Modulationsart und der Phasensynchronisationschaltung abhängt.

Fig. 2 veranschaulicht die Eigenschaften diese Signals. Fig. 2a zeigt dabei die phasenmässig leicht gedrehten Signalpunkte des Signals $\underline{Y}[k]$ in der komplexen Ebene. Fig. 2b zeigt die geschätzten Symbole. Die unerwünschte Drehung (Phasenfehler) des Signals $\underline{Y}[k]$ beruht auf dem Frequenzversatz des Empfängeroszillators 1 gegenüber dem Empfangssignal s(t). Dieser Phasenfehler lässt sich mit dem Synchronisationsverfahren aus dem eingangs zitierten Artikel von P.Y. Kam nicht elimieren.

Der grundlegende Gedanke der Erfindung besteht nun darin, dass die winkelmässige Differenz zwischen einem bestimmten Signalpunkt des Signals $\underline{Y}[k]$ und dem entsprechenden Symbol ausgenützt wird, um den exakten Frequenzversatz zu schätzen.

Die gewünschte, erwartungstreue Schätzung des Frequenzversatzes $\Delta f$ ergibt sich gemäss der Erfindung dann, wenn das phasenkorrigierte Signal $\underline{Y}[k]$ und das entsprechende Symbol $\underline{d}[k]$ gemäss folgender Beziehung miteinander verknüpft werden:

$$\hat{\Delta}_f T = \frac{1}{2\pi c} \arg\left(\underline{Y}[k]\cdot(\hat{\underline{d}}[k])^*\right) \quad \text{(II)}$$

(Der hochgestellte "*" bezeichnet den konjugiert komplexen Wert.) Die Wirkung der erfindungsgemässen Schätzung lässt sich auch anhand der Fig. 3 veranschaulichen. Sie zeigt die Phase $\theta$ des Produkts $(\underline{Y}[k]\cdot(\hat{\underline{d}}[k])^*)$ in Gegenwart eines Frequenzversatzes. Wenn aus dieser sich langsam ändernden Phase aufgrund der letzten aufeinanderfolgenden Symbolintervalle ein Mittelwert gebildet wird, dann ergibt sich zum aktuellen Zeitpunkt kT zwangsläufig ein Fehler $\Delta\theta$ (vgl. Fig. 3). Dieser Fehler ist erst dann bekannt, wenn das aktuelle Symbol $\underline{d}[k]$ richtig geschätzt worden ist. Dies macht sich nun die Erfindung zu Nutze, indem sie aufgrund der aktuellen Schätzung den aktuellen Frequenzversatz ermittelt und ihn mittels des Frequenzoszillators kompensiert.

Fig. 4 zeigt ein Blockschaltbild zur Implementation eines Frequenzversatzschätzers 8. Im Prinzip wird dabei die Formel II ausgewertet. Mit einer Rechenschaltung 10 wird das geschätzte aktuelle Symbol $\hat{\underline{d}}[k]$ in seinem konjugiert komplexen Wert $(\hat{\underline{d}}[k])^*$ transformiert. Der transformierte Wert wird mit dem entsprechenden Wert des Signals $\underline{Y}[k]$ multipliziert (Multiplizierer 9). Aus dem so erhaltenen Produkt extrahiert ein Phasenwinkeldetektor 11 das Argument. Eine Gewichtung des resultierenden Arguments mit einem geeigneten Faktor K (Multiplizierer 12) führt schliesslich zum gewünschten effektiven Frequenzversatz $\Delta f$. Der konkrete Wert des Faktors K hängt von den Einzelheiten der Phasenschätzung ab und lässt sich auf jeden Fall wie folgt darstellen:

$$K = \frac{1}{2\pi cT} \quad \text{(III)}$$

Im binären Fall (BPSK, M = 2) ergibt sich für eine vorangehende Phasensynchronisation mit einer Mitteilung über N Symbole

$$c = \frac{N+1}{2}$$

Die Gleichung (II) kann dann in die folgende einfache Form gebracht werden:

$$\hat{\Delta}_f T = \frac{1}{2\pi c} \arctan\left(\frac{\mathrm{Im}\{\underline{Y}[k]\}}{\mathrm{Re}\{\underline{Y}[k]\}}\right) \quad \text{(II')}$$

Damit steht der effektive Frequenzversatz $\Delta f$ zur Verfügung, um gemäss der Erfindung (vgl. Fig. 1) den Empfängeroszillator 1 nachzuregeln.

Wie bereits mehrfach angedeutet, eignet sich die Erfindung auch für nicht kohärente Demodulationsverfahren wie z. B. das MDPSK-Verfahren. Der Vorteil dieses Verfahrens liegt bekanntlich darin, dass die Phase nur differentiell ermittelt werden muss. Bei einem entsprechenden Empfänger ist somit die Phasensynchronisationsschaltung 6 gemäss Fig. 1 durch einen Phasendifferenzdetektor zu ersetzen. Dieser ermittelt eine differentielle Phase $\underline{Y}[k]$ gemäss folgender Beziehung:

$$\underline{Y}[k] = \underline{r}[k]\cdot(\underline{r}[k-l])^{*} \qquad \text{(IV)}$$

Die übrigen Teile der Empfängerschaltung sind entsprechend anzupassen.

Im Rahmen der Erfindung liegt eine grosse Zahl von Ausführungsformen. Im folgenden werden einige vorteilhafte Variationen kurz angedeutet.

Den genauen, erwartungstreuen Schätzwert erhält man natürlich nur, wenn die Schätzung gemäss der Formel (II) ausgeführt wird. Wenn man sich aber mit einer näherungsweisen Bestimmung zufrieden gibt, dann genügt durchaus auch die linealisierte Form dieser Formel. Die Linearisierung betrifft dabei die Berechnung des Arguments. Dabei wird im Prinzip die Linearität der Arcustangensfunktion beim Nulldurchgang verwendet. Die entsprechende suboptimale Rechenvorschrift lautet wie folgt:

$$\hat{\Delta}_f T = \frac{\mathrm{Im}\{\underline{Y}[k]\cdot(\hat{\underline{d}}[k])^{*}\}}{2\pi c\ \mathrm{Re}\{\underline{Y}[k]\cdot(\hat{\underline{d}}[k])^{*}\}}$$

Diese Näherung ist gut im Bereich eines kleinen Frequenzversatzes, d. h. $\Delta fT$ sehr viel kleiner als 1.

Versuche haben interessanterweise gezeigt, dass sich der Schätzalgorithmus auch dann stabilisiert, wenn der obenerwähnte Bereich zu Beginn nicht eingehalten wird.

Der näherungsweise ermittelte Frequenzversatz lässt sich z. B. als Fehlersignal für eine konventionelle Nachführregelung verwenden (vgl. auch den eingangs zitierten Artikel von F. Edbauer).

Der Wertebereich, über den sich die präsentierten Frequenzversatz-Schätzverfahren einsetzen lassen, ist bestimmt durch

$$-\frac{\alpha}{4\pi c} < \Delta ft < \frac{\alpha}{4\pi c}$$

wobei $\alpha$ den kleinsten Winkel zwischen zwei Signalpunkten in der Ebene $\underline{d}$ (vgl. Fig. 2b) bezeichnet.

Das Wesentliche der Erfindung liegt in der Schätzung des Frequenzversatzes. Wie dieser Frequenzversatz im einzelnen verwendet wird, um im Endeffekt die Phasenschätzung zu verbessern, hängt vom Einzelfall ab. Es ist nämlich nicht zwingend, dass der Frequenzoszillator, der zum Heruntermischen des Empfangssignals in das Basisband dient, auch zur Kompensation des Frequenzversatzes verwendet wird. Es ist z. B. durchaus möglich und sinnvoll, den Frequenzversatz allein auf digitaler Ebene zu kompensieren. Dies bedeutet, dass wie z. B. aus dem Artikel von Franz Edbauer bekannt, ein digitaler Oszillator implementiert wird, der entsprechend dem Frequenzversatz das digitalisierte Basisbandsignal zurückdreht.

Eine schnelle Kompensation ergibt sich wie erwähnt dann, wenn in jedem Symbolintervall die Phasenkorrektur gemäss Formel (II) durchgeführt wird. In vielen Fällen empfiehlt es sich aber, den Schätzwert über mehrere Intervalle (z. B. 10-100) zu mitteln, um das vom Uebertragungsweg herrührende Rauschen nlt) auszufiltern. Die Fehler des Frequenzoszillators 1 (Fig. 1) werden ohnehin ziemlich klein und konstant sein.

Zusammenfassend kann festgehalten werden, dass sich das erfindungsgemässe Schätzverfahren für den Frequenzversatz zur Regelung des Trägeroszillators des Empfängers heranziehen lässt, wobei sich die Symbolfehlerwahrscheinlichkeit reduziert.

## Patentansprüche

1. Verfahren zum Schätzen des Frequenzversatzes ($\Delta f$) eines Empfängeroszillators (1) gegenüber der Trägerfrequenz f eines Sendesignals (s(t)), welches M-wertige digitale Daten, die in Form von Symbolen ($\underline{d}[k]$) einer Trägerschwingung im Sinn eines Quadraturmodulationsverfahrens aufmoduliert sind, übermittelt, wobei im Empfänger
   a) zuerst mit Hilfe des Empfängeroszillators (1) das übermittelte Sendesignal (s(t) + n(t)) zu einem Basisbandsignal ($\underline{r}$(t)) heruntergemischt wird,
   b) dann entweder - im Fall einer kohärenten Demodulation - eine Phasensynchronisation erfolgt, die ein phasenkorrigiertes Signal $\underline{Y}$ von der Form

$$E[\underline{Y}[k]] = A_0 e^{j2\pi c \Delta f t} \underline{d}[k],$$

wobei E[.] = Erwartungswert, T = Symbolintervall, $\Delta f$ = Frequenzversatz, $\underline{d}[k]$ = Symbol oder - im Fall einer nichtkohärenten Demodulation - eine Phasendifferenzdetektion von der Form

$$\underline{Y}[k] = \underline{r}[k] \cdot (\underline{r}[k - l])^*,$$

wobei $\underline{r}[k]$ = Abtastwert des komplexwertigen Basisbandsignals; durchgeführt wird und

c) aus dem phasenkorrigierten Signal resp. der differentiellen Phase das entsprechende, übermittelte Symbol geschätzt wird, dadurch gekennzeichnet, dass

d) aus dem phasenkorrigierten Signal resp. aus der differentiellen Phase und dem entsprechenden geschätzten Symbol $\underline{d}[k]$ der Frequenzversatz zumindest näherungsweise gemäss der Beziehung

$$\hat{\Delta}_f T = \frac{1}{2\pi c} \arg \left(\underline{Y}[k] \cdot (\hat{\underline{d}}[k])^*\right)$$

ermittelt wird.

2. Verfahren nach Anspruch 1, dadurch gekennzeichnet, dass der Frequenzversatz exakt und damit erwartungstreu ermittelt wird.

3. Verfahren nach Anspruch 1, dadurch gekennzeichnet, dass der Frequenzversatz im Sinn einer Näherung gemäss der Beziehung

$$\hat{\Delta}_f T = \frac{\mathrm{Im}\{Y[k] \cdot (\hat{d}[k])^*\}}{2\pi c \ \mathrm{Re}\{\underline{Y}[k] \cdot (\hat{\underline{d}}[k])^*\}}$$

ermittelt wird.

4. Verfahren nach einem der Ansprüche 1 bis 3, dadurch gekennzeichnet, dass der Frequenzversatz über mehrere, insbesondere 10-100 Symbolperioden gemittelt wird.

5. Verfahren nach einem der Ansprüche 1 bis 4, dadurch gekennzeichnet, dass als Quadraturmodulationsverfahren ein QAM- oder MPSK-Verfahren verwendet wird.

6. Verfahren nach einem der Ansprüche 1 bis 4, dadurch gekennzeichnet dass als Quadraturmodulationsverfahren ein MDPSK-Verfahren verwendet wird.

7. Verfahren nach einem der Ansprüche 1 bis 6, dadurch gekennzeichnet, dass der geschätzte Frequenzversatz unmittelbar oder in gefilterter Form dem Empfängeroszillator (1) zur Kompensation des Frequenzversatzes $\Delta f$ zugeführt wird.

8. Verfahren nach einem der Ansprüche 3 bis 6, dadurch gekennzeichnet, dass der näherungsweise ermittelte Frequenzversatz als Fehlersignal für eine Kompensationsregelung des Frequenzversatzes des Basisbandsignals verwendet wird.

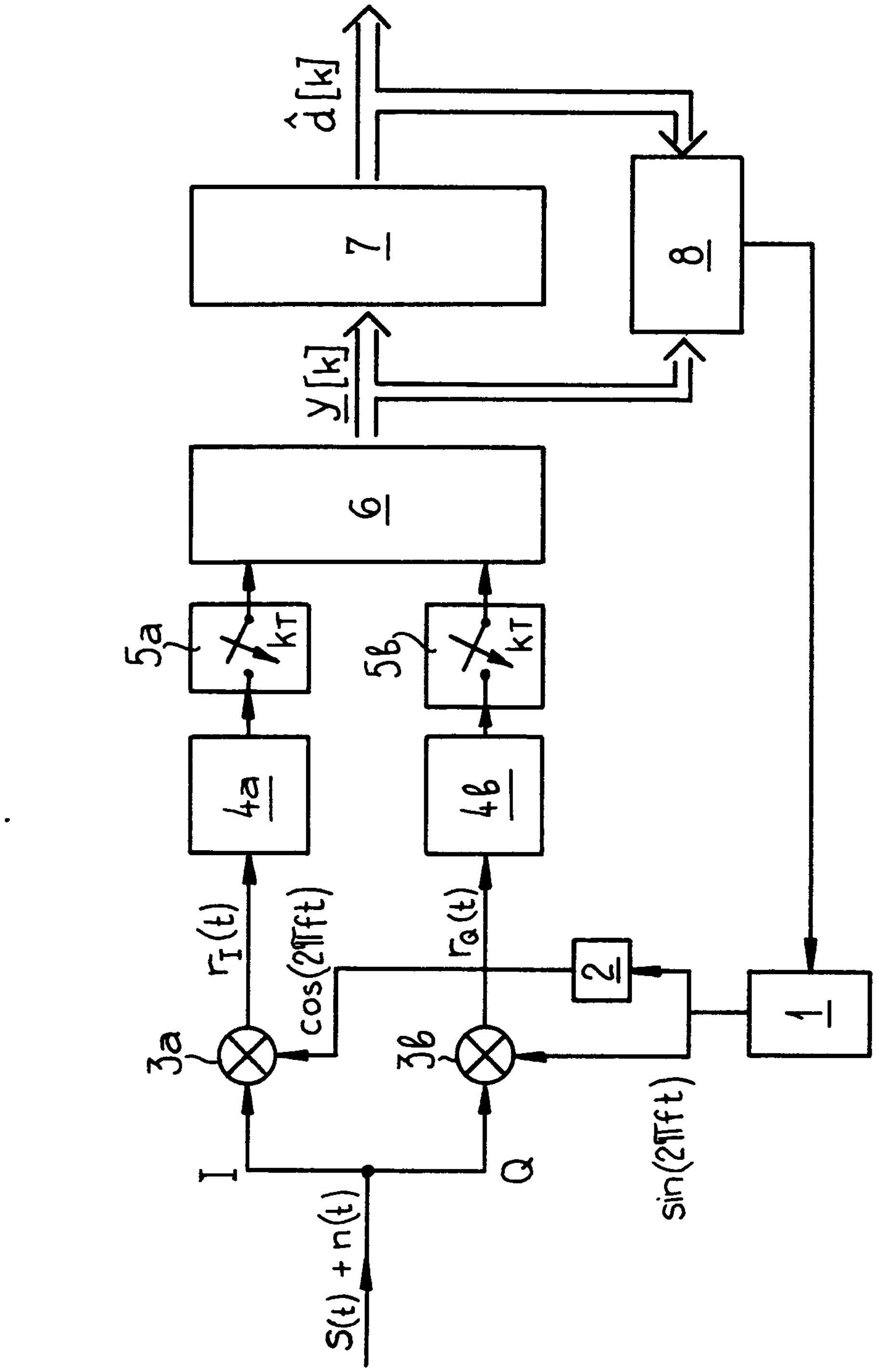
S(t) + n(t)
I
Q
3a
3b
cos(2πft)
sin(2πft)
r_I(t)
r_Q(t)
4a
4b
5a
5b
kT
kT
6
y[k]
7
d̂[k]
8
1
2

Fig.1

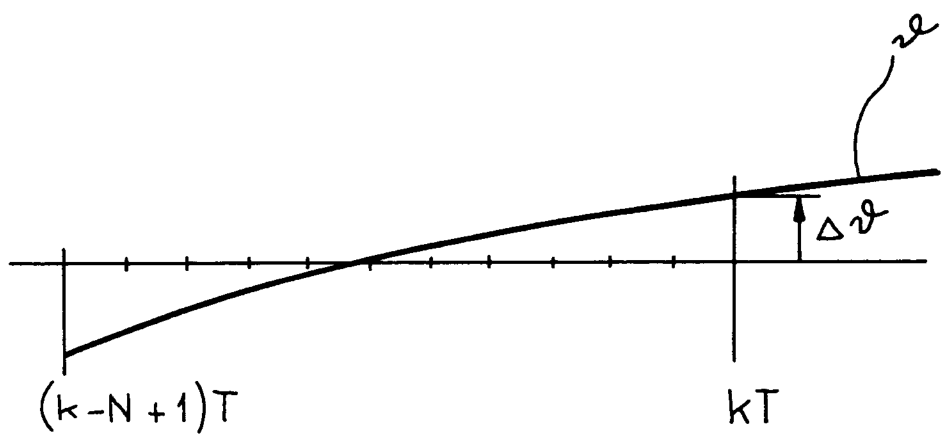


Fig.3

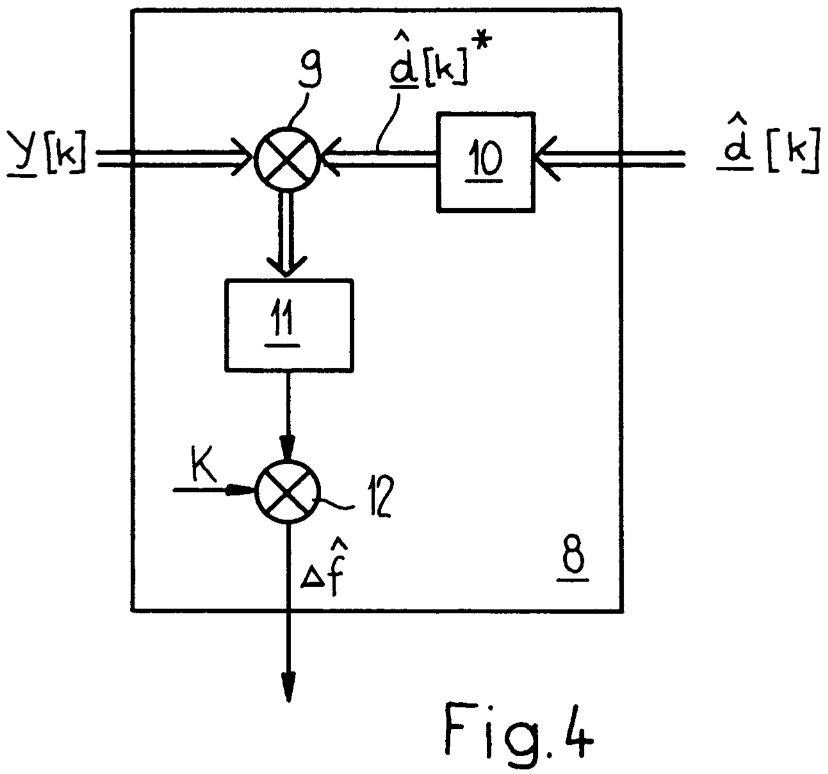


Fig.4

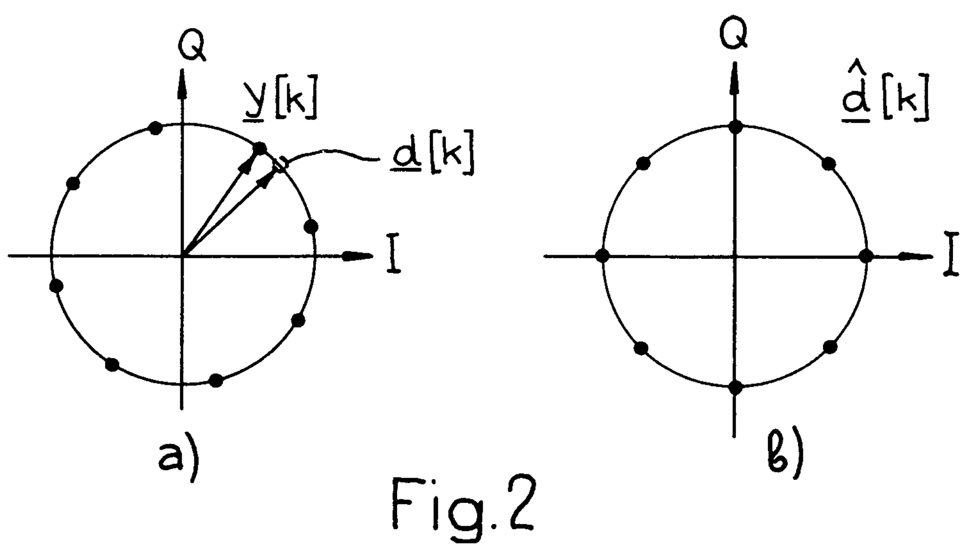


Fig.2